# EUROPEAN PATENT APPLICATION

(11) **EP 4 726 472 A1**
(43) Date of publication of application: **15.04.2026**
(21) Application number: 24205650.5
(22) Date of filing: 09.10.2024
(51) Int. Cl.: G03F 7/00

(54) **A METROLOGY TOOL AND A METHOD FOR DETERMINING PARAMETERS OF INTEREST**

(71) Applicant: ASML Netherlands B.V., 5500 AH Veldhoven (NL)
(72) Inventor: MATHIJSSEN, Simon Gijsbert Josephus, 5500 AH Veldhoven (NL); NOOT, Marc Johannes, 5500 AH Veldhoven (NL); MC NAMARA, Elliott Gerard, 5500 AH Veldhoven (NL); DEN BOEF, Arie Jeffrey, 5500 AH Veldhoven (NL)
(74) Representative: ASML Netherlands B.V.

(57) **Abstract**

The application provides a metrology tool, and a method, for determining parameters of interest of a structure on an object. This metrology tool comprises: an illumination branch configured for providing an illumination beam; a spectral shaping device for spectrally shaping the illumination beam providing a spectrum comprising at least two disjunct wavelength bands; a controller and a detection branch configured for detecting signals relating to a diffracted beam, the beam comprising diffracted sub-beams, wherein the signals enable determining parameters of interest. The illumination branch is further configured for illuminating the structure on the object which results in the diffracted beam. Each of the diffracted sub-beams is associated with one of the at least two disjunct wavelength bands. The controller is configured for selecting the spectrum allowing distinguishably acquiring the signals from respective diffracted sub-beams and the controller is configured for controllably setting the spectral shaping device to provide the spectrum.

## Description

### FIELD

The present invention relates to a metrology tool for determining one or more parameters of interest of a structure on an object and a method for determining one or more parameters of interest of a structure on an object.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

In lithographic processes, it is desirable to make frequently measurements of the structures or patterns created, e.g., for process control and verification. Tools to make such measurement are typically called metrology tools or metrology devices.

Such a metrology tool can thus be for determining one or more parameters of interest of a structure on an object. Such a structure on an object can for example be a target with a specified pitch.

A known metrology tool achieves this with an illumination beam; the illumination beam being spatially shaped by a spatial filter (e.g., an aperture or apodizer); a wavelength selection device to control the spectrum of the illumination beam and a detector to capture radiation from the sample.

When the known tool is used in an application where illumination of a structure on an object is required with more than one wavelength, the multiple wavelengths are provided by the wavelength selection device. In this known tool each of the multiple wavelengths corresponds to a different parameter of interest recipe, with the goal of detecting multiple parameter of interest signals. An example of such a parameter of interest can be overlay, in which case an overlay signal is detected for each of the multiple wavelengths, each signal corresponding to a different recipe.

Upon illuminating the structure on the object, the illumination beam diffracts, where the diffraction angles are wavelength and target pitch dependent. The different wavelengths will be spatially separated into a spatial distribution. To provide a useful readout of the parameter of interest it is important to provide a strong signal. The signal will typically be weak if there is lots of overlap of the wavelengths on the detector, and typically strong if there is little overlap. In the known tool the diffracted illumination is captured using additional multiple optical elements to separate the different wavelengths and direct them to different segments on the detector.

A downside of such a known tool is that additional multiple optical elements are required to separate the different wavelengths to direct the diffracted illumination to different segments on the detector, this also increases costs and complexity of the tool.

### SUMMARY

According to a first aspect of the invention, there is provided a metrology tool for determining one or more parameters of interest of a structure on an object. This metrology tool comprises: an illumination branch configured for providing an illumination beam; a spectral shaping device for receiving and spectrally shaping the illumination beam providing a spectrum comprising at least two disjunct wavelength bands; a controller and a detection branch configured for detecting signals relating to a diffracted beam, the diffracted beam comprising diffracted sub-beams, wherein the signals enable determining the one or more parameters of interest. The forementioned illumination branch is further configured for illuminating the structure on the object with at least a portion of the spectrally shaped illumination beam. This illuminating of the structure results in the diffracted beam, comprising the forementioned diffracted sub-beams. Each of the diffracted sub-beams is associated with one of the at least two disjunct wavelength bands. The controller is configured for selecting the spectrum allowing distinguishably acquiring the signals from respective diffracted sub-beams and the controller is configured for controllably setting the spectral shaping device to provide the selected spectrum. Enabling distinguishably acquirable signals in a tool setup as described in this specification results in a high contrast image leading to a stronger signal to extract the parameter of interest In addition, less optical elements are required to guide the diffracted sub-beams and enable acquiring the signals as this is enabled by the selecting of the spectrum. By reducing the amount of components both the complexity and cost of the tool reduces.

In an embodiment the detection branch of the metrology tool further comprises optical elements for directing the diffracted beam towards the detector. An effect of this embodiment is that the diffracted beam can steered or manipulated or prepared for improved detecting.

In an embodiment each diffracted sub-beam is detectable as a diffracted beam spot formed at an angular resolved plane, wherein each diffracted beam spot is associated with a diffracted sub-beam.

In an embodiment the distinguishably acquirable signals from respective diffracted sub-beams are distinguishable when the overlap of the diffracted beam spots is less than 90%. An effect of this embodiment is that due not having a complete overlap a better signal over noise is achieved to more accurately determine a parameter of interest.

In an embodiment the metrology tool further comprises a spatial filter for spatially shaping the illumination beam. An effect of this embodiment is that depending on the specific structure on the object and/or the spectrum the illumination beam can be further optimized for improved detection.

According to a second aspect of the invention, there is provided a method for determining one or more parameters of interest of a structure on an object. This method comprises: providing an illumination beam; spectrally shaping the illumination beam providing a spectrum comprising at least two disjunct wavelength bands; illuminating the structure on the object resulting in a diffracted beam comprising diffracted sub-beams, wherein each diffracted sub-beam is associated with one of the at least two disjunct wavelength bands; detecting signals relating to the diffracted beam, wherein the signals enable determining the one or more parameters of interest. The provided spectrum comprising at least two disjunct wavelengths bands is controllably selected allowing distinguishably acquiring the signals from respective diffracted sub-beams.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell
- Figure 3 depicts a schematic representation of holistic lithography, representing a cooperation between three key technologies to optimize semiconductor manufacturing;
- Figure 4 depicts a schematic overview of a metrology apparatus;
- Figures 5(a), 5(b), 5(c) and 5(d) comprise (a) a schematic diagram of a dark field scatterometer for use in measuring targets, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 schematically depicts an overview of a metrology tool according to a first aspect of the invention;
- Figures 7(a), 7(b), 7(c), 7(d), 7(e), 7(f), 7(g) and 7(h) schematically depict examples of wavelength-intensity spectra;
- Figures 8(a), 8(b), 8(c), 8(d) and 8(e) comprise (a) a schematic depiction of an illumination beam, (b) a schematic depiction of a spatial distribution, (c) a schematic depiction of diffracted sub-beams, (d) a schematic depiction of diffracted sub-beams and (e) a schematic depiction of diffracted sub-beams;
- Figures 9(a), 9(b) and 9(c), comprise (a) a schematic depiction of a wavelength-intensity spectrum, (b) a schematic depiction of swing curve and (c) a schematic depiction of diffracted sub-beams;
- Figures 10(a), 10(b) and 10(c), comprise (a) a schematic depiction of a wavelength-intensity spectrum, (b) a schematic depiction of swing curve and (c) a schematic depiction of diffracted sub-beams;
- Figure 11 schematically depicts an overview of a metrology tool according to an embodiment of the invention, similarly as to figure 6.
- Figure 12 schematically depicts a black diagram that illustrates a computer system that may assist in implementing the methods and flows disclosed herein.

### DETAILED DESCRIPTION

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

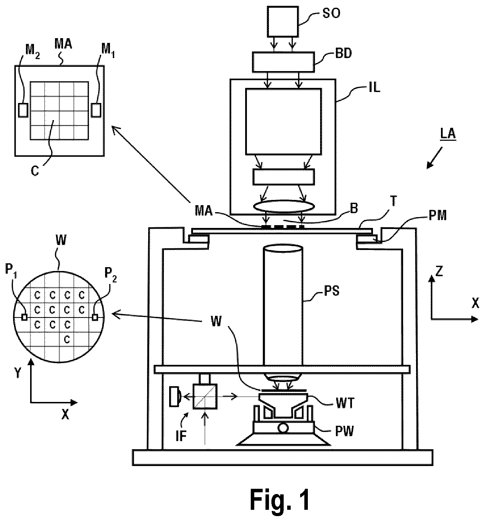

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

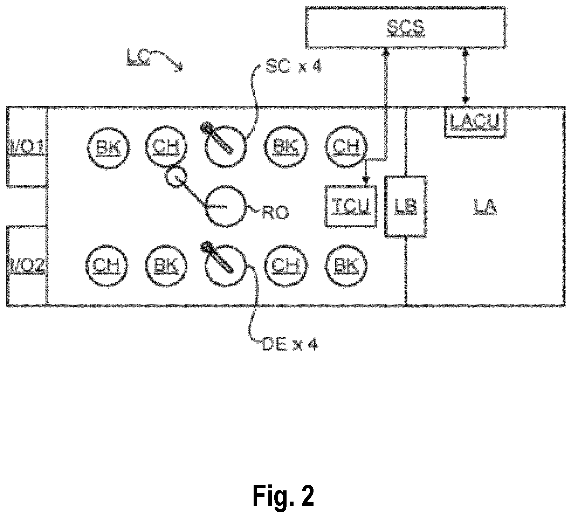

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time. An example of such multiple target measurements can be found in US patent application US..., incorporated herein by reference in its entirety.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and not yet published US patent application 15/181,126, incorporated herein by reference in its entirety.

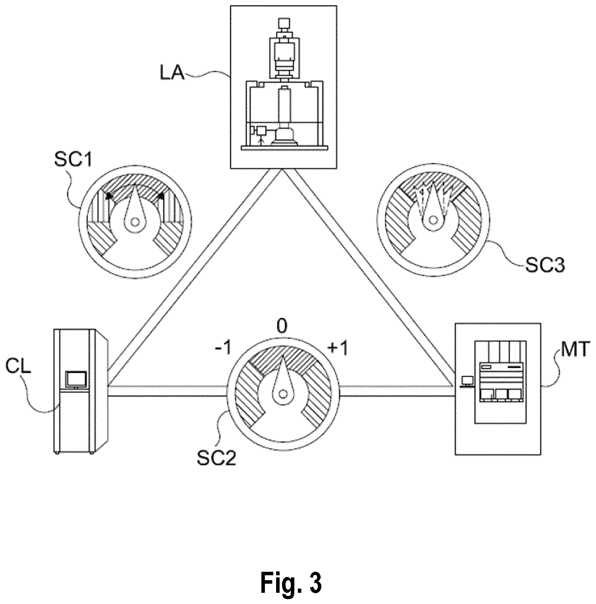

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

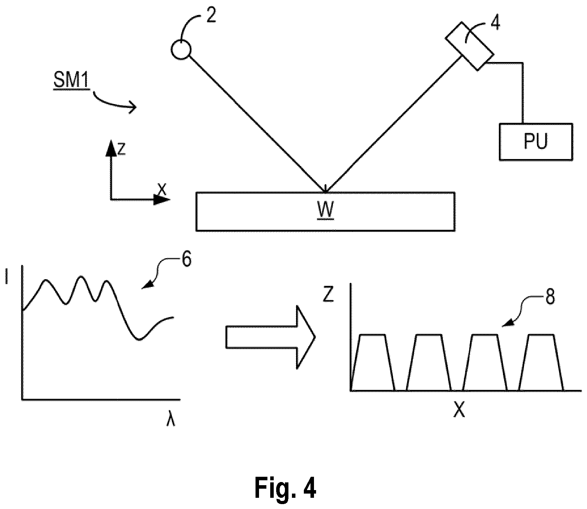

A metrology apparatus, such as a scatterometer, is depicted in figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

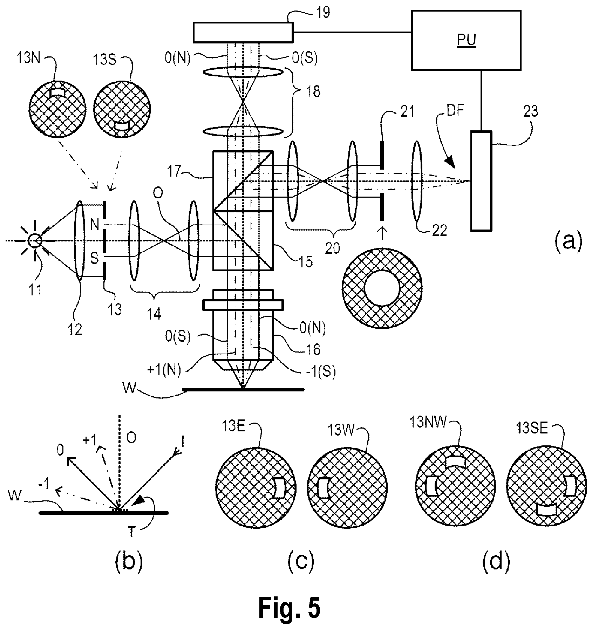

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Alternatively, an angular resolved image, which can also be referred to as a pupil plane image, can be captured by a detector based on this (intermediate) pupil-plane. Therefore, the angular range at which the radiation is incident on the substrate can be selected by defining a spatial intensity distribution in a plane that presents the spatial spectrum of the substrate plane, here referred to as a (conjugate) pupil plane which can also be more broadly referred to as an angular resolved plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. In another embodiment the target may be underfilled where the rays cover an area smaller than the area of target T. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

Optionally, a second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction or other characteristics of interest.

Optionally, in the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In the discussions hereafter an apparatus as described above is assumed, however the main application is in the forementioned first measurement branch with a sensor or detector in an angular resolved plane.

A scatterometer comprises a radiation source, which can be broadband source (i.e. one with a wide range of radiation frequencies or wavelengths), whereby the light is incoherent (such as a plasma discharge based source) or coherent (such as a supercontinuum source). Such a scatterometer is an example of a metrology apparatus.

A scatterometer comprises further wavelength selection module, which can also be referred to as a color selection module, suitable to select a wavelength of interest in the range of, say, 405-790 nm or even lower, such as 200-300 nm, or even higher, in the Infra-Red range of wavelengths, for example up to 1600 nm. There are different examples of such color selection modules which will be further described below.

A scatterometer comprises further a detector which may measure the intensity of scattered radiation or light at a single wavelength (or narrow wavelength range), the intensity separately at multiple wavelengths or integrated over a wavelength range. Furthermore, the detector may separately measure the intensity of transverse magnetic- and transverse electric-polarized radiation or light and/or the phase difference between the transverse magnetic- and transverse electric-polarized radiation or light. The different wavelengths of radiation may be measured either sequentially or simultaneously using, for example, an imaging spectrometer. For example a color CCD detector may be used to measure the intensities at three different wavelengths for a three color source. The imaging spectrometer may conveniently be located in the detection branch of the apparatus.

Further, the detector is configured to separate the detected radiation into a plurality of sub-divisions, the radiation of each sub-division having a different value for the characteristic. Further, the inspection apparatus may also include an imaging spectrometer configured to separate the detected radiation into a plurality of sub-divisions, the radiation of each sub-division having a different value for the characteristic.

A performance parameter of great interest is overlay. Other parameters of performance of the patterning process can be calculated, such as CD, focus, dose. In the US patent application publications 14/948,001 or 15/181,126, enclosed herein by reference in their entirety, various techniques are disclosed for improving the quality of overlay measurements.

Further, a metrology target measurement recipe can be used that specifies one or more parameters of the measurement using the measurement system. In an embodiment, the term "metrology target measurement recipe" includes one or more parameters of the measurement itself, one or more parameters of a pattern measured, or both.

In this context, a pattern measured (also referred to as a "target" or "target structure") may be a pattern that is optically measured, e.g., whose diffraction is measured. The pattern measured may be a pattern specially designed or selected for measurement purposes. Multiple copies of a target may be placed on many places on a substrate. For example, a metrology target measurement recipe may be used to measure overlay. In an embodiment, a metrology target measurement recipe may be used to measure another process parameter (e.g., dose, focus, CD, etc.) In an embodiment, a metrology target measurement recipe may be used for measuring alignment of a layer of a pattern being imaged against an existing pattern on a substrate; for example, a metrology target measurement recipe may be used to align the patterning device to the substrate, by measuring a relative position of the substrate.

In an embodiment, if the metrology target measurement recipe comprises one or more parameters of the measurement itself, the one or more parameters of the measurement itself can include one or more parameters relating to a measurement beam and/or measurement apparatus used to make the measurement. For example, if the measurement used in a metrology target measurement recipe is a diffraction-based optical measurement, one or more parameters of the measurement itself may include a wavelength of measurement radiation, and/or a polarization of measurement radiation, and/or measurement radiation intensity distribution, and/or an illumination angle (e.g., incident angle, azimuth angle, etc.) relative to the substrate of measurement radiation, and/or the relative orientation relative to a pattern on the substrate of diffracted measurement radiation, and/or number of measured points or instances of the target, and/or the locations of instances of the target measured on the substrate. The one or more parameters of the measurement itself may include one or more parameters of the metrology apparatus used in the measurement, which can include detector sensitivity, numerical aperture, etc.

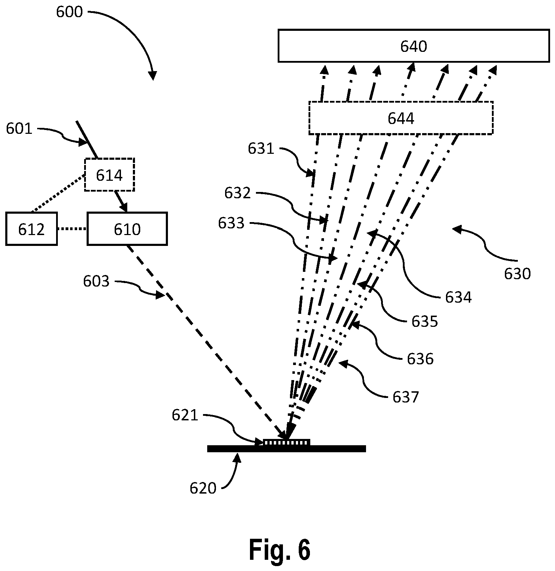

Figure 6 schematically depicts an overview of a metrology tool 600 for determining one or more parameters of interest of a structure 621 on an object 620. An illumination branch is configured for providing an illumination beam 601. The illumination beam 601 can be a broadband light, for example a white light, in a range of 400 nm to 1600 nm, or a range of 500 nm to 1050 nm. This illumination beam 601 can originate from for example a supercontinuum source, a Laser Pumped Plasma Source, a white light LED, an incandescent lamp, or any other suitable light source that generates broadband light.

The illumination beam 601 is received by a spectral shaping device 610. The spectral shaping device 610 spectrally shapes the illumination beam 601 providing a spectrum comprising at least two disjunct wavelength bands.

Such a wavelength band can also be referred to as a spectral band, and can be understood as comprising a central wavelength and a spectral bandwidth. The central wavelength will typically be the wavelength having the highest relative intensity within a wavelength band, but more generally this is the power-weighted mean wavelength within the wavelength band. The bandwidth can typically be defined as the full width at half maximum (FWHM) of the spectral band. An example of such a wavelength band can then for example be a central wavelength of 550 nm with a bandwidth of 100 nm, or a central wavelength of 650 nm with a bandwidth of 5 nm. Such a wavelength band will typically resemble a Gaussian-distribution on the wavelength-intensity spectrum, of which examples will be discussed further down below.

A spectral shaping device 610 can for example be a Spatial Light Modulator (SLM) or a Grating Light Valve (GLV). Such a SLM or GLV are further described in patent applications US6947613B and EP4279993A1, which are incorporated herein by reference in their entirety. Another example of a spectral shaping device 610 could be an arrangement of spectral filters. Such an arrangement of spectral filters is further described in EP patent application number 24173626.3 filed on May 1, 2024 and EP patent application number 24175326.8 filed on May 13, 2024.. In an example arrangement as described in the referred patent applications multiple spectral filters are arranged in such a way that a spectrum with disjunct wavelength bands can be obtained. Furthermore in such an arrangement of spectral filters, which can also be referred to as color filters, the spectral filters can for example be, but are not limited to, linear variable filters, angle of incidence dependent filters, dielectric filters or acousto-optic filters. Another example of a spectral shaping device 610 is a Micro Mirror Array (MMA) or a Digital Micromirror Device (DMD). Such a MMA or DMD are further described in patent application US20230229094A1 which is incorporated herein by reference in their entirety. Another example of a spectral shaping device 610 is a monochromator.

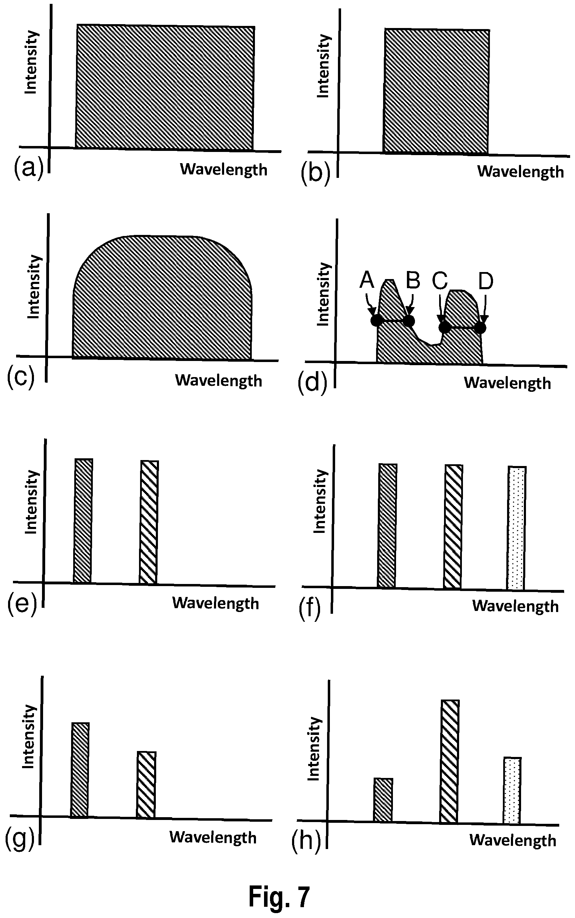

Spectrally shaping the illumination beam 601 can be understood as altering the wavelength-intensity spectrum of the radiation and results in a spectrally shaped illumination beam 603. Spectrally shaping will be further described down below in the description of figure 7, as will a further description of providing a spectrum comprising at least two disjunct wavelength bands. A different way to refer to a wavelength-intensity spectrum is the spectral density (SD) or spectral power density (SPD).

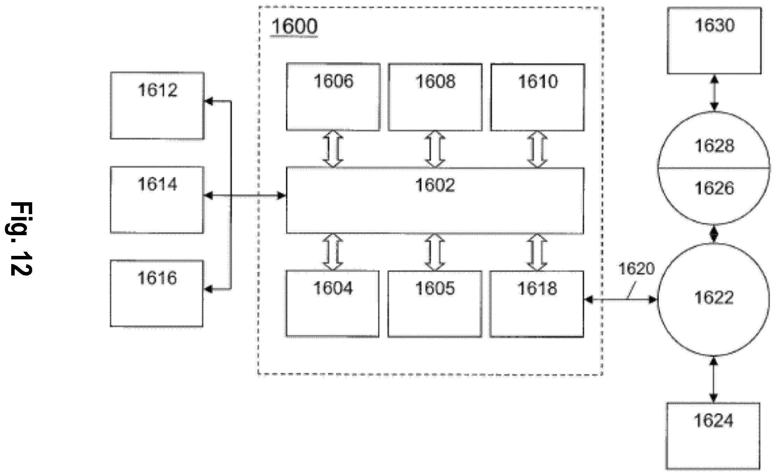

To spectrally shape the illumination beam 601 a controller 612 is configured for controllably setting the spectral shaping device 610 to provide the spectrum. Such a controller 612 can for example be an integrated computer or a processing device of the metrology tool 600 or a standalone computer or computer system such as further described in the description of figure 12. In an embodiment the controller can also control other elements of the tool, such as but not limited to for example the substrate support or stage. By controllably setting the spectral shaping device it is meant that the spectral shaping device 610 gets configured to provide a requested output spectrum by changing one of the characteristics of the spectral shaping device 610. For example, in the case of the GLV such a configuration could be the controlling of the individual ribbons to control the reflection and diffraction of the illumination beam 601, resulting in the spectrally shaped beam 603.

Optionally, the illumination branch further comprises a spatial filter 614 for spatially shaping the illumination beam 601. Such a spatial filter 614 can for example be an aperture or apodizer. The spatially shaped illumination beam comprises an illumination sub-beam. Depending on the spatial shaping of the illumination beam, more than one illumination sub-beam can be provided. Optionally, each of the illumination sub-beams can be spectrally shaped by the spectral shaping device 610, or alternatively some of the illumination sub-beams can be spectrally shaped by the spectral shaping device 610. In such cases the spectral shaping does not necessarily need to be the same between the illumination sub-beams.

It will be appreciated that, although in the description above it is suggested that first the illumination beam 601 is spectrally shaped by the spectral shaping device 610, and second the spectrally shaped beam 603 is optionally spatially shaped by the spatial filter 614, the sequence can also be the other way around. In an embodiment it is possible that first the illumination beam 601 is optionally spatially shaped by the spatial filter 614, and second is spectrally shaped by the spectral shaping device 610.

Furthermore the illumination branch is configured for illuminating the structure 621 on the object 620 with at least a portion of the spectrally shaped illumination beam 603. Such an object 620 can for example be a substrate which can also be referred to as a wafer as described above. Such a structure 621 can also be referred to as a pattern or a target or a target structure as described above. Such a target may be a grating with regular pitch.

As described above upon illuminating the structure 621 on the object 620, the spectrally shaped illumination beam 603 diffracts resulting in a diffracted beam 630. The diffraction angles are wavelength and target pitch dependent. The different wavelengths will be spatially separated into a spatial distribution. Such a spatial distribution can be imagined as having one or more diffracted sub-beams (631, 632, 633, 634, 635, 636, 637) together forming the diffracted beam 630. In the schematic example of figure 6 there are 7 sub-beams drawn, but it will be appreciated that there can also be less than 7 sub-beams or more than 7 sub-beams. Each sub-beam is associated with one of the at least two disjunct wavelength bands. For wavelength bands to be disjunct we mean that there is very little or no overlap between these wavelength bands. More precisely there is very little or no overlap of the intensities of each wavelength band above the imaginary line between the points forming the FWHM of each wavelength band. Or in other words, there is very little or no overlap of the intensities of each wavelength band which are located within the FWHM. Examples of such disjunct and non-disjunct wavelength bands will be further discussed in the description of figure 7.

The metrology tool 600 further comprises a detection branch configured for detecting a signal relating to the diffracted beam 630. The detected signal enables determining the one or more parameters of interest. Although it would be possible to determine such a parameter of interest from a single signal, typically more than a single signal will be detected so for sake simplicity in the further description signals will be used.

Optionally, the detection branch is further configured for detecting an angular resolved image of the diffracted beam 630. Each diffracted sub-beam is detectable as a diffracted beam spot formed at an angular resolved plane, wherein each diffracted beam spot is associated with a diffracted sub-beam.

Optionally, the detection branch further comprises a detector 640 arranged at the angular resolved plane for detecting the angular resolved image. Such a detector 640 can for example be a CCD or CMOS sensor or detector.

Optionally, the detection branch further comprises optical elements 644 for directing the diffracted beam 630 towards the detector 640. Such optical elements 644 can for example be one or more lenses, mirrors, fibres or wave guides. With directing the beam we mean that the beam or the radiation of the beam can be directed, shaped or controlled by the forementioned optical elements 644.

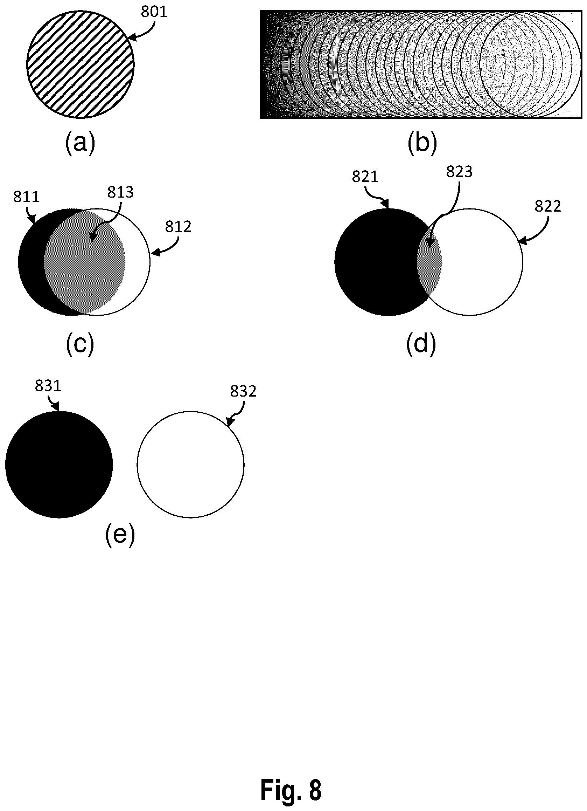

To determine or measure such a parameter of interest, it is beneficial to detect a strong signal related to or associated with such a parameter. It is well known that for a metrology tool as described here the signal strength is dependent on for example the target characteristics, the illumination wavelength or wavelength band and the diffraction efficiency. Such a target characteristic can for example be the pitch. To detect a strong signal associated with such a target it is therefore necessary to be able to distinguish signals coming from different targets with different characteristics, and/or signals originating from a different wavelength or wavelength band. The signals thus have to be distinguishably acquirable from each diffracted sub-beam associated with one of the at least two disjunct wavelength bands. This will be further explained in the description of figures 8, 9 and 10. It should be noted here as well that the controller 612 is further configured for selecting the spectrum allowing distinguishably acquiring the signals from respective diffracted sub-beams. In the optional case of the illumination branch further comprising a spatial filter 614, the controller 612 is further configured to provide the spectrum given a characteristic of the spatial filter 614. Such a characteristic of the spatial filter 614 can for example be a size and/or a shape of a spatially filtering feature of the spatial filter 614. This spatially filtering feature can for example be but is not limited to a hole in an aperture or apodizer, or an arrangement of micro-mirrors. To provide different spatially filtering features for example the diameter of feature can be changed, or the shape of feature can be changed. Optionally, the controller 612 is further configured for selecting or controlling any parameter related to the measurement recipe.

Figure 7 schematically depicts examples of wavelength-intensity spectra. Figure 7(a) depicts an example broadband spectrum ranging from relatively very short till very long wavelengths all with equal intensity. Figure 7(b) depicts a similar spectrum as shown in figure 7(a), with the difference that this spectrum is a relatively more narrowband spectrum, with in this example a wavelength range from relatively short till long wavelengths. Also here all wavelengths have an equal intensity. Figures 7(a) and 7(b) could be typical examples of the illumination beam 601 before any spectral shaping has been done.

Figures 7(c) and 7(d) depict examples of the spectra in 7(a) and 7(b), with the difference that the intensities of the wavelengths are not equal. For example, in figure 7(c) the shortest and longest wavelengths have a relatively smaller intensity compared to the middle wavelengths. Similarly in figure 7(d), with additionally an even smaller relative intensity for the middle wavelengths leading to a spectrum with disjunct wavelength bands. Figures 7(c) and 7(d) could be typical examples of a spectrum which is spectrally shaped by altering the wavelength-intensity spectrum of the radiation.

Another example is depicted in figure 7(e) where two disjunct wavelength bands are shown with equal intensities. Similar as in figure 7(e), two disjunct wavelength bands are shown in figure f(g), with the difference that here the intensities are not equal. I will be appreciated that such spectra can also comprise more than two wavelength bands, as shown in figures 7(f) and 7(h) with three disjunct wavelength bands. Figures 7(e), 7(f), 7(g) and 7(h) could also be typical examples of spectra which are spectrally shaped.

The figures 7(a), 7(b) and 7(c) are examples for non-disjunct wavelength bands, whereas the figures 7(d), 7(e), 7(f), 7(g) and 7(h) are examples of disjunct wavelength bands. In an embodiment disjunct means that in the wavelength band examples there is very little or no overlap of the intensities of each wavelength band above the imaginary line between the points forming the FWHM of each wavelength band. Or in other words, there is very little or no overlap of the intensities of each wavelength band which are located within the FWHM. In the schematic example of figure 7(d) such imaginary lines are drawn from point A to B and from point C to D, where these points form the boundaries of the FWHM of each wavelength band.

Spectrally shaping with a spectral shaping device 610 can thus be understood as providing a requested output spectrum by altering the wavelength-intensity spectrum of the illumination beam 601 and results in a spectrally shaped illumination beam 603.

A spectrum comprising at least two disjunct wavelength bands can then for example be a spectrum as shown in figures 7(d), 7(e) or 7(g). It will be appreciated that other examples can be imagined with more than two disjunct wavelength bands (like for example figures 7(f) and 7(h), or other examples with other shapes of the spectrum.

Distinguishly acquiring the signals from respective diffracted sub-beams associated with one of the at least two disjunct wavelength bands will be further explained here in the description of figures 8, 9 and 10.

Figure 8(a) schematically depicts an illumination beam 601 as a circular beam spot 801 as it would be received by for example an optical element like a lens, or for example the spectral shaping device 610, or the object 620. It will be appreciated that the shape of such a spot does not necessarily have to be circular, but can also for example be oval shaped. As explained above, upon illuminating the structure 621 on the object 620, the spectrally shaped illumination beam 603 diffracts resulting in a diffracted beam 630. This diffracted beam 630 is formed by sub-beams associated with the spatial distribution.

Figure 8(b) schematically depicts such a spatial distribution of the diffracted beam 630 formed by sub-beams. As for the illumination beam, each of the circles represents such a diffracted sub-beam as it would be detected in an angular resolved plane and is associated with a wavelength band from the illumination beam. In this example many sub-beams are present associated with many different wavelength bands. Such a spatial distribution as shown in figure 8(b) could for example be associated with an illumination beam with a spectrum as shown in figures 7(a), 7(b) or 7(c).

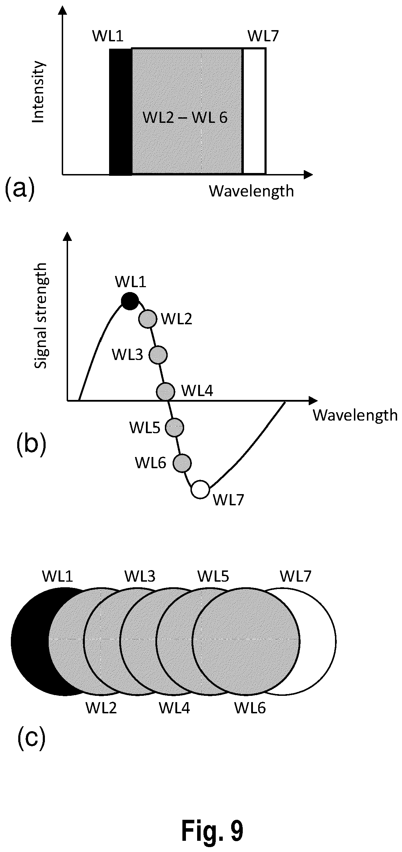

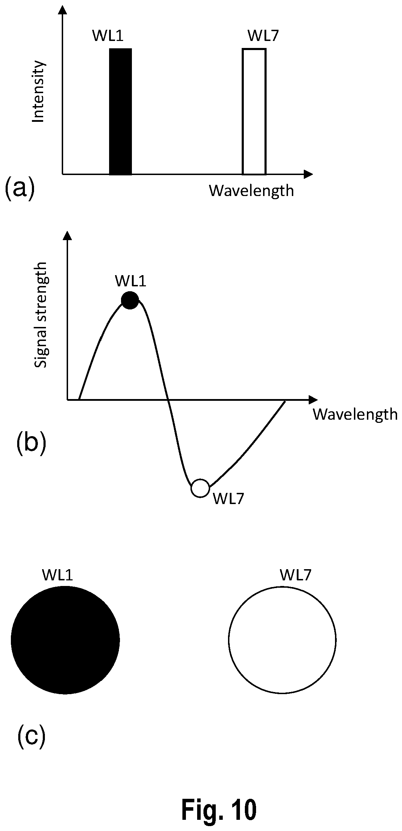

Figure 8(c) schematically depicts as an example two diffracted sub-beams 811 and 812, as they would be detected in an angular resolved plane, associated with two wavelength bands. In this example there is considerable overlap between the sub-beams as depicted by the region 813. The region 813 can be understood as an overlapping area or overlapping region defined as the area defined by beam spot 812 that covers at least a part of an area defined by beam spot 811, or vice versa. Similarly this is applicable for other overlapping regions or areas described further down below. Having such a considerable overlap region makes it difficult to detect a strong signal as it is difficult to distinguishably acquire the signals related to each sub-beam 811 and 812. This will be further explained in the description of figures 9 and 10.

Figure 8(d) schematically depicts a similar example as in figure 8(c), with the difference that in this example the two diffracted sub-beams 821 and 822, as they would be detected in an angular resolved plane, have a very small overlap region 823. Having such a small overlap region makes it easier to detect a strong signal as it is easier to distinguishably acquire the signals related to each sub-beam 821 and 822. Such a spatial distribution as shown in figure 8(d) could for example be associated with an illumination beam with a spectrum as shown in figure 7(d).

Figure 8(e) schematically depicts another similar example as figures 8(c) and 8(d), with the difference that in this example that there is no overlap region between the sub-beams 831 and 832, as they would be detected in an angular resolved plane. This would create the easiest situation to distinguishably acquire the signals related to each sub-beam 831 and 832. Such a spatial distribution as shown in figure 8(e) could for example be associated with an illumination beam with a spectrum as shown in figures 7(e) or 7(g) .

Figure 9(a) schematically depicts an example wavelength-intensity spectrum from an illumination beam 601. In this particular schematic example a limited number of wavelengths are depicted as WL1 until WL7. It will be appreciated that this is purely a schematic representation and there can be more or less than seven such WLs.

As described above it is well known that the signal strength is dependent on the target characteristics and the illumination wavelength or wavelength band. This is typically represented as a swing curve such as schematically depicted in figure 9(b). For a specific target characteristic each particular wavelength WL has a certain response or signal strength when acquiring that signal. In the shown particular example the WL1 and WL7 have the strongest response, whereas WL2 until WL6 have a less-strong response. It is therefore of interest in determining one of more parameters of interest of a structure 621 on an object 620 to acquire those strongest signals as they are most sensitive.

Figure 9(c) schematically depicts similar diffracted sub-beams, as they would be detected in an angular resolved plane, as was shown and described for figures 8(b) until 8(e), but in this case applied to the example of figures 9(a) and 9(b). The different spots WL1 until WL7 can be seen as associated with the sub-beams 631 until 637 from figure 6, where WL1 is associated with sub-beam 631, WL2 is associated with sub-beam 632 and so on. In this example there is a very large overlap region formed by the WLs WL2 until WL6 (or rather their associated sub-beams 632 until 636). This leads to sub-optimal acquiring of the signals relating to the diffracted beam 630 as the most relevant signals associated with WL1 and WL7(related to sub-beams 631 and 637) as not distinguishably acquirable from the other sub-beams.

Figures 10(a), 10(b) and 10(c) schematically depict the situation where the signals are distinguishably acquirable from respective diffracted sub-beams, wherein each diffracted sub-beam is associated with one of the at least two disjunct wavelength bands.

Figure 10(a) schematically depicts, similarly to figure 9(a) an example wavelength-intensity spectrum from an illumination beam 601. In this particular schematic example two disjunct wavelength bands are depicted, WL1 and WL7. These correspond similarly as in figure 9(b) to a certain signal strength or sensitivity as shown in figure 10(b). As explained above when such disjunct wavelength bands are selected the resulting spatial distribution of the diffracted sub-beams, as they would be detected in an angular resolved plane, will have little or no overlapping regions as shown in figure 10(c). This leads to a situation where distinguishable acquiring the signals relating to the diffracted sub-beams is easier and provides a stronger signal, which in turn benefits the determining of the parameter of interest.

In an example the distinguishably acquirable signals from respective diffracted sub-beams are distinguishable when the overlap of the diffracted beam spots is less than 90%, where the overlap is to be understood as for example the overlap region 823 as described above in the description of figure 8(c). In another example this is the case when the overlap of the diffracted beam spots is less than 75%. Such a large overlap of 75% or 90% could for example be the case in an example as shown and described for figure 9(c). In another example this is the case when the overlap of the diffracted beam spots is less than 60%. In another example this is the case when the overlap of the diffracted beam spots is less than 50%. It will be appreciated that depending on the use case a different percentage of overlap will be tolerated or accepted to enable determining the parameter of interest. It will be appreciated that in certain cases there will be a minimum amount of overlap of the diffracted beam spots, for example an overlap which is at least 5%, or at least 10%, or at least 20% or at least 30%. In an embodiment it could then be that the distinguishably acquirable signals from respective diffracted sub-beams are distinguishable when the overlap of the diffracted beam spots is less than 90% and more than 5%, or any other combination of overlap percentage ranges.

As explained above different parameters of interest can be considered like for example overlay or critical dimension (CD). Such a parameter of interest can also be referred to as process parameter.

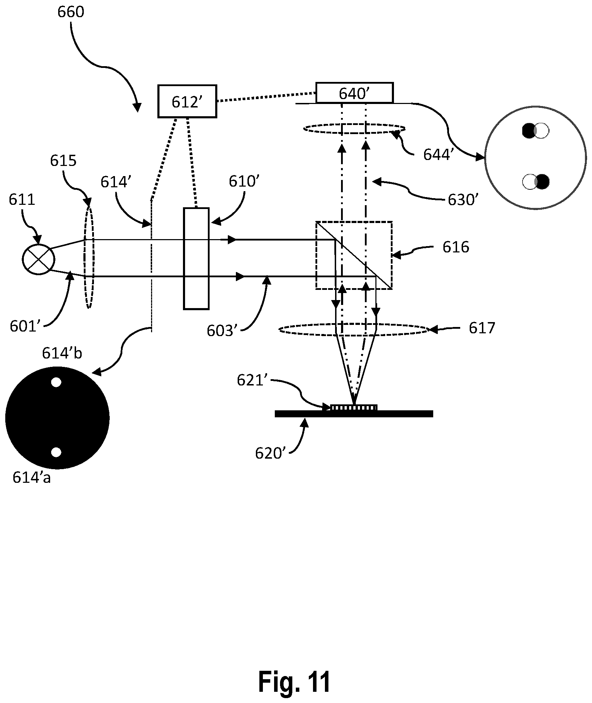

Figure 11 schematically depicts an overview of a metrology tool 660 according to an embodiment of the invention, similarly as metrology tool 600. An illumination branch is configured for providing an illumination beam 601'. The illumination beam 601' can be a broadband light, for example a white light, in a range of 400 nm to 1600 nm, or a range of 500 nm to 1050 nm. This illumination beam 601' originates from a source 611, for example a supercontinuum source, a Laser Pumped Plasma Source, a white light LED, an incandescent lamp, or any other suitable light source that generates broadband light.

Optionally, the illumination branch further comprises optical elements 615 for directing the illumination beam towards a spatial filter 614' (as similarly provided for metrology tool 600). Such optical elements 615 can for example be one or more lenses, mirrors, fibres or wave guides. With directing the beam we mean that the beam or the radiation of the beam can be directed, shaped or controlled by the forementioned optical elements 615. The spatial filter 614' spatially shapes the illumination beam. For example, two illumination sub-beams 614'a and 614'b could be provided, as shown here in an angular resolved plane of the metrology tool 660.

Similarly as for metrology tool 600, the illumination beam 601' is received by a spectral shaping device 610'. The spectral shaping device 610' spectrally shapes the illumination beam 601' providing a spectrum comprising at least two disjunct wavelength bands, resulting in a spectrally shaped illumination beam 603'.

To spectrally shape the illumination beam 601' a controller 612' is configured for controllably setting the spectral shaping device 610' to provide the spectrum, similarly as described above in the description of figure 6 on the metrology tool 600. Additionally, similarly as described above in the description of figure 6 the controller 612' is further configured for selecting the spectrum allowing distinguishably acquiring the signals from respective diffracted sub-beams. In the optional case of the illumination branch further comprising a spatial filter 614', the controller 612' is further configured to provide the spectrum given a characteristic of the spatial filter 614'. As described above the sequence of first providing a spectrally shaped spectrum and then a spatially shaped beam can also be reversed.

Optionally, the controller 612' is further configured for processing the signals of the image obtained by the detector 640' and calculate the parameter of interest. Although it is not specified in the description of figure 6, also there in the example of metrology tool 600 the controller 600 could optionally be further configured for processing the signals of the image obtained by the detector 640 and calculate the parameter of interest.

As described above in the description of figure 6 also here in an embodiment the controller can also control other elements of the tool, such as but not limited to for example the substrate support or stage. Such a controller 612' can for example be an integrated computer or a processing device of the metrology tool 660 or a standalone computer or computer system such as further described in the description of figure 12.

Furthermore the illumination branch is configured for illuminating the structure 621' on the object 620' with at least a portion of the spectrally shaped illumination beam 603'. Optionally, there is provided a beam splitting and/or combining optical element 616 to receive and direct the spectrally shaped illumination beam 603' towards the structure 621' on the object 620'. Such an optical element 616 can for example be a Polarizing Beam Splitter (PBS). Optionally, additional optical elements 617 are provided to, similarly as optical element 615, direct the spectrally shaped illumination beam 603' towards the structure 621' on the object 620'.

As described above upon illuminating the structure 621' on the object 620', the spectrally shaped illumination beam 603' diffracts resulting in a diffracted beam 630'.

The metrology tool 660 further comprises a detection branch configured for detecting signals relating to the diffracted beam 630'. The detected signals enable determining the one or more parameters of interest. Similar as described for figure 8(d) diffracted sub-beams as they would be detected in an angular resolved plane are shown. In this example there are diffracted sub-beams for each of the illumination sub-beams 614'a and 614'b.

Optionally, the detection branch further comprises a detector 640' arranged at the angular resolved plane for detecting the angular resolved image. Such a detector 640' can for example be a CCD or CMOS sensor or detector.

Optionally, the detection branch further comprises optical elements 644' for directing the diffracted beam 630' towards the detector 640'. Such optical elements 644' can for example be one or more lenses, mirrors, fibres or wave guides. With directing the beam we mean that the beam or the radiation of the beam can be directed, shaped or controlled by the forementioned optical elements 644'.

There is furthermore provided a method for determining one or more parameters of interest of a structure on an object. This method comprises: providing an illumination beam; spectrally shaping the illumination beam providing a spectrum comprising at least two disjunct wavelength bands; illuminating the structure on the object resulting in a diffracted beam comprising diffracted sub-beams, wherein each diffracted sub-beam is associated with one of the at least two disjunct wavelength bands; detecting a signal relating to the diffracted beam, wherein the signal enables determining the one or more parameters of interest. The provided spectrum comprising at least two disjunct wavelengths bands is controllably selected allowing distinguishably acquiring the signals from respective diffracted sub-beams.

In summary, this application provides a metrology tool, and a method, for determining parameters of interest of a structure on an object. This metrology tool comprises: an illumination branch configured for providing an illumination beam; a spectral shaping device for spectrally shaping the illumination beam providing a spectrum comprising at least two disjunct wavelength bands; a controller and a detection branch configured for detecting signals relating to a diffracted beam, the beam comprising diffracted sub-beams, wherein the signals enable determining parameters of interest. The illumination branch is further configured for illuminating the structure on the object which results in the diffracted beam. Each of the diffracted sub-beams is associated with one of the at least two disjunct wavelength bands. The controller is configured for selecting the spectrum allowing distinguishably acquiring the signals from respective diffracted sub-beams and the controller is configured for controllably setting the spectral shaping device to provide the spectrum.

Further embodiments are disclosed in the subsequent list of numbered clauses:
1. A metrology tool for determining one or more parameters of interest of a structure on an object, the metrology tool comprising:
   - an illumination branch configured for providing an illumination beam;
   - a detection branch configured for detecting signals relating to a diffracted beam, the diffracted beam comprising diffracted sub-beams, wherein the signals enable determining the one or more parameters of interest;
   - a spectral shaping device for receiving and spectrally shaping the illumination beam providing a spectrum comprising at least two disjunct wavelength bands;
   - a controller,
   wherein the illumination branch is further configured for illuminating the structure on the object with at least a portion of the spectrally shaped illumination beam resulting in the diffracted beam, wherein each diffracted sub-beam is associated with one of the at least two disjunct wavelength bands and the controller is configured for selecting the spectrum allowing distinguishably acquiring the signals from respective diffracted sub-beams and the controller is configured for controllably setting the spectral shaping device to provide the selected spectrum.
2. A metrology tool as defined in clause 1, wherein the detection branch is further configured for detecting an angular resolved image of the diffracted beam.
3. A metrology tool as defined in any of the previous clauses, wherein each diffracted sub-beam is detectable as a diffracted beam spot formed at an angular resolved plane, wherein each diffracted beam spot is associated with a diffracted sub-beam.
4. A metrology tool as defined in clause 3, further comprising a detector arranged at the angular resolved plane for detecting the angular resolved image.
5. A metrology tool as defined in clause 4, further comprising optical elements for directing the diffracted beam towards the detector.
6. A metrology tool as defined in clause 3, 4 or 5, wherein distinguishably acquirable signals from respective diffracted sub-beams are distinguishable when the overlap of the diffracted beam spots is less than 90% .
7. A metrology tool as defined any of the previous clauses, further comprising a spatial filter for spatially shaping the illumination beam.
8. A metrology tool as defined in clause 7, wherein the spatially shaped illumination beam comprises an illumination sub-beam.
9. A metrology tool as defined in clause 7 or 8, wherein the controller is further configured to provide the spectrum given a characteristic of the spatial filter.
10. A metrology tool as defined in clause 9, wherein the characteristic of the spatial filter is a size and/or a shape of a spatially filtering feature of the spatial filter.
11. A metrology tool as defined in any of the previous clauses, wherein the spectral shaping device is a Grating Light Valve or a Spatial Light Modulator.
12. A metrology tool as defined in any of the previous clauses, wherein one of the one or more parameters of interest is overlay.
13. A metrology tool as defined in any of the previous clauses, wherein the illumination beam is configured for providing a spectrum that at least partially overlaps with a range of 400 to 1600 nm .
14. A lithographic apparatus comprising the metrology tool as defined in any of the previous clauses.
15. A lithographic cell comprising the metrology tool as defined in any of the clauses 1 to 14 or the lithographic apparatus as defined in clause 15.
16. A method for determining one or more parameters of interest of a structure on an object, the method comprising :
   - providing an illumination beam;
   - spectrally shaping the illumination beam providing a spectrum comprising at least two disjunct wavelength bands;
   - illuminating the structure on the object resulting in a diffracted beam comprising diffracted sub-beams, wherein each diffracted sub-beam is associated with one of the at least two disjunct wavelength bands;
   - detecting signals relating to the diffracted beam, wherein the signals enable determining the one or more parameters of interest;
   wherein the provided spectrum comprising at least two disjunct wavelengths bands is controllably selected allowing distinguishably acquiring the signals from respective diffracted sub-beams.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Figure 12 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

## Claims

1. A metrology tool for determining one or more parameters of interest of a structure on an object, the metrology tool comprising:
- an illumination branch configured for providing an illumination beam;
- a detection branch configured for detecting a signal relating to a diffracted beam, the diffracted beam comprising diffracted sub-beams, wherein the signal enables determining the one or more parameters of interest;
- a spectral shaping device for receiving and spectrally shaping the illumination beam providing a spectrum comprising at least two disjunct wavelength bands;
- a controller,
wherein the illumination branch is further configured for illuminating the structure on the object with at least a portion of the spectrally shaped illumination beam resulting in the diffracted beam, wherein each diffracted sub-beam is associated with one of the at least two disjunct wavelength bands and the controller is configured for selecting the spectrum allowing distinguishably acquiring the signals from respective diffracted sub-beams and the controller is configured for controllably setting the spectral shaping device to provide the selected spectrum.

2. A metrology tool as claimed in claim 1, wherein the detection branch is further configured for detecting an angular resolved image of the diffracted beam.

3. A metrology tool as claimed in any of the previous claims, wherein each diffracted sub-beam is detectable as a diffracted beam spot formed at an angular resolved plane, wherein each diffracted beam spot is associated with a diffracted sub-beam.

4. A metrology tool as claimed in claim 3, further comprising a detector arranged at the angular resolved plane for detecting the angular resolved image.

5. A metrology tool as claimed in claim 4, further comprising optical elements for directing the diffracted beam towards the detector.

6. A metrology tool as claimed in claim 3, 4 or 5, wherein distinguishably acquirable signals from respective diffracted sub-beams are distinguishable when the overlap of the diffracted beam spots is less than 90%.

7. A metrology tool as claimed any of the previous claims, further comprising a spatial filter for spatially shaping the illumination beam.

8. A metrology tool as claimed in claim 7, wherein the spatially shaped illumination beam comprises an illumination sub-beam.

9. A metrology tool as claimed in claim 7 or 8, wherein the controller is further configured to provide the spectrum given a characteristic of the spatial filter.

10. A metrology tool as claimed in claim 9, wherein the characteristic of the spatial filter is a size and/or a shape of a spatially filtering feature of the spatial filter.

11. A metrology tool as claimed in any of the previous claims, wherein the spectral shaping device is a Grating Light Valve or a Spatial Light Modulator.

12. A metrology tool as claimed in any of the previous claims, wherein the illumination beam is configured for providing a spectrum that at least partially overlaps with a range of 400 to 1600 nm.

13. A lithographic apparatus comprising the metrology tool as claimed in any of the previous claims.

14. A lithographic cell comprising the metrology tool as claimed in any of the claims 1 to 13 or the lithographic apparatus as claimed in claim 14.

15. A method for determining one or more parameters of interest of a structure on an object, the method comprising:
- providing an illumination beam;
- spectrally shaping the illumination beam providing a spectrum comprising at least two disjunct wavelength bands;
- illuminating the structure on the object resulting in a diffracted beam comprising diffracted sub-beams, wherein each diffracted sub-beam is associated with one of the at least two disjunct wavelength bands;
- detecting a signal relating to the diffracted beam, wherein the signal enables determining the one or more parameters of interest;
wherein the provided spectrum comprising at least two disjunct wavelengths bands is controllably selected allowing distinguishably acquiring the signals from respective diffracted sub-beams.
